Europäisches Patentamt

European Patent Office

Office européen des brevets

(11) Publication number: **0 579 983 A1**

# EUROPEAN PATENT APPLICATION

(21) Application number: **93110343.6**

(51) Int. Cl.5: **C23C 16/26**, C23C 14/06

(22) Date of filing: **29.06.93**

(30) Priority: **02.07.92 JP 175682/92**
**30.11.92 JP 319646/92**
**14.06.93 JP 142101/93**

(43) Date of publication of application:
**26.01.94 Bulletin 94/04**

(84) Designated Contracting States:
**DE GB NL**

(71) Applicant: **SUMITOMO ELECTRIC INDUSTRIES, LIMITED**
**5-33, Kitahama 4-chome**
**Chuo-ku**
**Osaka(JP)**

(72) Inventor: **Kazuhiko Oda, c/o Itami Works of Sumitomo**
**Elec.Ind.Ltd.,**
**1-1, Koyakita 1-chome,**
**Itami-shi**
**Hyogo(JP)**
Inventor: **Yasuhisa Yushio, c/o Itami Works of Sumitomo**
**Elec.Ind.Ltd.,**
**1-1, Koyakita 1-chome,**
**Itami-shi**
**Hyogo(JP)**
Inventor: **Makoto Setoyama, c/o Itami Works of Sumitomo**
**Elec.Ind.Ltd.,**
**1-1, Koyakita 1-chome,**
**Itami-shi**
**Hyogo(JP)**
Inventor: **Takashi Yoshioka, c/o Itami Works of Sumitomo**
**Elec.Ind.Ltd.,**
**1-1, Koyakita 1-chome,**
**Itami-shi**
**Hyogo(JP)**

(74) Representative: **Patentanwälte Kirschner & Grosse**
**Forstenrieder Allee 59**
**D-81476 München (DE)**

(54) **Impurity-containing hard carbon film.**

(57) Provided according to the present invention is a hard carbon film having both of excellent wear resistance and high conductivity. Also provided is a hard carbon film having small internal stress, which can sufficiently maintain excellent slidability. An amorphous hard carbon film which is mainly composed of carbon, or carbon and hydrogen, and contains at least one impurity element other than carbon and hydrogen has electrical resistivity of at least $1 \times 10^{-6}$ $\Omega \cdot cm$ and not more than $1 \times 10^2$ $\Omega \cdot cm$ at the room temperature. An amorphous hard carbon film which is mainly composed of carbon, or carbon and hydrogen, and contains at least one impurity element other than carbon and hydrogen contains the impurity element other than carbon and hydrogen in concentration of at least 0.001 atomic percent and not more than 40 atomic percent, and has internal stress of at least $1 \times 10^8$ dyne/cm² and not more than $7 \times 10^9$ dyne/cm².

## BACKGROUND OF THE INVENTION

### Field of the Invention

The present invention relates to a hard carbon film, and more specifically, it relates to a hard carbon coating film having wear resistance and good sliding properties, which is applied to a coating for a sliding material.

### Description of the Background Art

A hard carbon film is also called diamond-like carbon (DLC), amorphous carbon (a-C:H) or i-C. Such a hard carbon film is mainly composed of carbon, and additionally contains hydrogen in an amount of 0.05 to 0.5 atomic percent with respect to carbon atoms. Such a hard carbon film is in an amorphous atomic structure containing a large amount of sp3 bonds, which may conceivably incorporate hydrogen atoms to terminate in unpaired bonds of carbon atoms. The hard carbon film has properties which are similar to those of diamond, such as extremely high Knoop hardness of several thousands in general, extremely high insulativity with electrical resistivity of $10^6$ to $10^{14}$ $\Omega \cdot cm$, and transparency against infrared rays. Through such properties, the hard carbon film is applied to various materials such as a surface protective coating and an optical material.

As to such a hard carbon film, attempts have been made to reduce its electrical resistivity to about $10^2$ to $10^6$ $\Omega \cdot cm$ by adding a small amount of an element selected from those belonging to the groups III and V of the periodic table, as described in Japanese Patent Publications Nos. 61-53955 (1986) and 4-28785 (1992).

The aforementioned hard carbon film can be prepared by any of the following methods:

(1) Plasma CVD (chemical vapor deposition) of decomposing gaseous hydrocarbon with plasma and depositing the same on a substrate.

(2) Sputtering, called ion beam sputtering, of depositing carbon particles which are sputtered from a carbon target on a substrate by impact of ions derived from a plasma state.

(3) Ion plating of passing solid carbon through plasma in vapor deposition for activating and depositing the carbon.

(4) Ion beam evaporation of applying carbon or hydrocarbon ions having energy of about several hundred eV to 1 keV from a plasma state for forming a film.

(5) Laser ablation of irradiating a carbon target with a laser for depositing carbon particles emitted in plasma.

A hard carbon film which is formed by such a method has an extremely smooth surface, with a small friction coefficient. When a surface which is coated with such a hard carbon film is brought into frictional contact with a counter material, damage of the counter material is rather reduced. Thus, the hard carbon film is recently watched with interest as a coating for a surface of a sliding material.

In more concrete terms, application/development of such a hard carbon film is studied in various fields in relation to audio-visual apparatuses such as video and audio apparatuses, business equipment such as a hard disk, a printer, a facsimile and a copying machine, and the like.

On the other hand, graphite is currently the most general material for a sliding material which must have conductivity. Graphite has low electrical resistivity of $0.2 \times 10^{-3}$ to $4 \times 10^{-3}$ $\Omega \cdot cm$, due to participation of $\pi$ electrons left by sp2 bonding. Further, graphite has a friction coefficient of about 0.1 with respect to a metal in general, conceivably because hexagonal bonding along a c-axis direction is so weak that sliding is caused in a c-plane direction. Due to such specific properties, graphite is applied to a sliding part of a carbon brush or the like, to which electrical contact is required.

A conventional hard carbon film is an ideal material with respect to a sliding part which must slide in a non-lubricant coefficient, since the same has a small friction coefficient of 0.05 to 0.2 and is extremely hard to wear due to high hardness. Further, such a hard carbon film is a specific material which exhibits extremely small attack against a counter material of sliding. As to (1) electrical resistivity and (2) internal stress, however, the conventional hard carbon film has the following problems:

### (1) Problems in Electrical Resistivity

The conventional hard carbon film is not applicable to a sliding part to which electrical contact is required, due to high electrical resistivity of $10^6$ to $10^{14}$ $\Omega \cdot cm$.

Further, sliding between insulators often results in a problem of electrification. Due to its high insulativity, the hard carbon film frequently causes electrification when the counter material of sliding is formed by an insulator. In a magnetic recording medium increasing coming into the market in recent years, for example, such electrification leads to adhesion of dust, occurrence of noise and breakage of the medium. Despite its excellent slidability, therefore, it is difficult to apply the hard carbon film to a magnetic recording medium or the like. Further, Coulomb attraction resulting from electrification is disadvantageously caused between the hard carbon film and the counter material to apparently increase a friction load, leading to increase in frictional force.

In order to prevent such a phenomenon, a carbon brush or the like is employed to release such electrification. However, this countermeasure is not sufficiently satisfactory due to increase in number of components, although it is technically possible to prevent electrification by this method.

The sliding part may be prepared from graphite, which is an excellent sliding material capable of achieving electrical contact with no problem of electrification dissimilarly to the hard carbon film. However, graphite, which is a self-lubricant material sliding with self abrasion, results in extremely larger abrasion loss as compared with the hard carbon film. When the sliding part is prepared from graphite, therefore, the component must be frequently exchanged.

On the other hand, it is also possible to apply the hard carbon film described in each of the aforementioned two gazettes (Japanese Patent Publications Nos. 61-53955 and 4-28785) to a sliding part. Namely, it is possible to prevent the problem of electrification by applying a hard carbon film having low electrical resistivity of $10^2$ to $10^6$ $\Omega \cdot cm$. In practice, however, the aforementioned electrification cannot be sufficiently prevented unless a hard carbon film having lower electrical resistivity is employed.

Thus, it has generally been impossible to obtain a hard carbon film having both of excellent wear resistance and high conductivity.

## (2) Problems in Internal Stress

In general, a hard carbon film has extremely high internal stress of $5 \times 10^9$ to $3 \times 10^{10}$ dyne/cm$^2$. When such a hard carbon film is in excess of several 1000 Å in thickness, therefore, this film is easily separated due to stress accumulation. Therefore, a general hard carbon film is employed in a relatively small film thickness of about 1000 to 3000 Å.

When such a hard carbon film is formed on a substrate of a hard material such as cemented carbide or SiC ceramics, slidability with a low friction coefficient can be maintained for a relatively long time even if the hard carbon film coating the substrate has a small thickness. For example, a hard carbon film which is formed on an SiC substrate gives a friction coefficient of not more than half and abrasion loss of several percent as compared with those attained with no provision of such a hard carbon film.

When the hard carbon film is formed on a substrate of a soft material such as an aluminum alloy or a stainless steel, however, this substrate is easily deformed by a load which is applied in sliding. When the substrate itself is thus deformed, it is impossible to sufficiently maintain excellent slidability with a low friction coefficient. In this case, the hard carbon film may be increased in thickness, not to transfer the load applied in sliding to the substrate. Due to restriction by the aforementioned internal stress, however, it is impossible to increase the thickness of the hard carbon film in excess of 1000 to 3000 Å. Thus, a thick hard carbon film cannot be formed due to its high internal stress. When the hard carbon film is formed on a substrate of a soft material, therefore, it is difficult to sufficiently maintain excellent slidability with a low friction coefficient.

As hereinabove described, it is difficult to sufficiently maintain excellent slidability in the conventional hard carbon film. This problem remarkably arises particularly when the hard carbon film is formed on a substrate of a soft material, and hence it is impossible to sufficiently effectuate the properties of the hard carbon film.

## SUMMARY OF THE INVENTION

An object of the present invention is to provide a hard carbon film having both of excellent wear resistance and high conductivity.

Another object of the present invention is to provide a hard carbon film having small internal stress, which can sufficiently maintain excellent slidability.

The inventors have made deep study to find that it is possible to obtain a hard carbon film having both of excellent wear resistance and high conductivity by adding an impurity other than carbon and hydrogen to the hard carbon film.

3

Accordingly, a hard carbon film according to an aspect of the present invention is an amorphous hard carbon film which is mainly composed of carbon, or carbon and hydrogen, and contains at least one impurity element other than carbon and hydrogen. This hard carbon film has electrical resistivity of at least $1 \times 10^{-6}$ $\Omega \cdot cm$ and not more than $1 \times 10^2$ $\Omega \cdot cm$ at the room temperature.

While it has not been clarified in detail why the inventive hard carbon film has conductivity, there may conceivably exist a mechanism due two types of conduction, depending on impurity concentration.

The first conduction is impurity conduction or hopping conduction in a region having a small impurity content. Introduction of an impurity into the hard carbon film leads to impurity levels, whereby impurity conduction or hopping conduction is caused through the impurity levels. In other words, electrons or holes localized in atoms of the as-added impurity jump across the impurity atoms, to be transported. When concentration of the impurity element is increased, a hopping probability is increased and electrical resistance is generally reduced. Thus, it is possible to easily change the resistivity of the hard carbon film by controlling the amount of the added impurity element.

The second conduction is ordinary conduction which is caused by the so-called free electrons in a region having a large impurity content. In such a region having a large impurity content, the impurity added into the film forms a quasi-continuous or continuous matrix. Transportation of the free electrons is caused through this matrix.

Thus, it is possible to prevent adhesion of dust and occurrence of noise by reducing electrical resistivity of the hard carbon film even if a friction surface is charged upon sliding with an insulating material, since the electric charges are neutralized through the hard carbon film having low resistivity.

The hard carbon film according to this aspect of the present invention has electrical resistivity of at least $1 \times 10^{-6}$ $\Omega \cdot cm$ and not more than $1 \times 10^2$ $\Omega \cdot cm$ at the room temperature. Such resistivity of the carbon film unlimitedly approaches that ($10^6$ $\Omega \cdot cm$ to $10^{14}$ $\Omega \cdot cm$) of a hard carbon film containing no additive when the amount of the as-added impurity is unlimitedly reduced. It is said that resistivity of about $10^2$ $\Omega \cdot cm$ to $10^6$ $\Omega \cdot cm$ is sufficient for preventing electrification, which is disadvantageous for the present invention. Thus, the upper limit of resistivity is set to be not more than the maximum resistance value of $1 \times 10^2$ $\Omega \cdot cm$, at which electrification can be prevented. However, such resistivity is preferably minimized in order to effectively prevent electrification. A general metal has resistivity of about $1 \times 10^{-6}$ $\Omega \cdot cm$ to $3 \times 10^{-4}$ $\Omega \cdot cm$ at the room temperature. When the impurity content is increased, resistivity of the hard carbon film according to the aspect of the present invention unlimitedly approaches that of the impurity, while the film cannot have resistivity which is lower than the said value in theory. Thus, the lower limit of the resistivity is set to be at least $1 \times 10^{-6}$ $\Omega \cdot cm$.

Graphite, which is applied to a brush for bringing a sliding part into electrical contact, has resistivity of about $10^{-4}$ $\Omega \cdot cm$ to $10^{-3}$ $\Omega \cdot cm$. On the other hand, a material such as Au, Ag or Cu (copper) which is applied to an electrode or a wire has resistivity of about $1 \times 10^{-6}$ $\Omega \cdot cm$ to $3 \times 10^6$ $\Omega \cdot cm$, while a material such as W, Ta or nichrome which is applied to a resistor has resistivity of $5 \times 10^{-6}$ $\Omega \cdot cm$ to $10^{-4}$ $\Omega \cdot cm$. Therefore, the hard carbon film according to the aspect of the present invention is applicable to an electrode, an electrode contact or a resistor which is mainly prepared from a metal, in addition to a sliding part.

According to another preferred aspect of the present invention, the hard carbon film contains the impurity element in concentration of at least 0.001 atomic percent and not more than 40 atomic percent.

When the amount of the added impurity is increased in order to reduce resistivity, wear resistance and slidability such as a friction coefficient tend to deteriorate. In order to attain conductivity without lowering wear resistance and slidability, the concentration of the as-added impurity element is preferably not more than 40 atomic percent. As to the lower limit of the impurity content, the resistivity is not reduced below $1 \times 10^6$ $\Omega \cdot cm$ unless at least 0.0001 atomic percent of the impurity is added when W is added by plasma CVD, for example. When An is added by ion implantation, on the other hand, the resistivity is reduced below $1 \times 10^6$ $\Omega \cdot cm$ even if the impurity content is 0.000001 atomic percent. Thus, the lower limit of the resistivity is varied with the as-added element and the method of addition. Therefore, the lower limit of the impurity content in the inventive hard carbon film is preferably set to be not more than 0.001 atomic percent, in consideration of the types of employable elements.

As to impurity element adding methods other than ion implantation, impurity concentration is preferably set in a range of at least 0.00001 atomic percent since it is difficult to control concentration of less than 0.00001 atomic percent.

The inventors have also made deep study to find that it is possible to obtain a hard carbon film having internal stress within a prescribed range by adding a desired amount of an impurity other than carbon and hydrogen to the film.

Accordingly, a hard carbon film according to still another aspect of the present invention is an amorphous hard carbon film which is mainly composed of carbon, or carbon and hydrogen, and contains at least one impurity element other than carbon and hydrogen. This film contains the impurity element other than carbon and hydrogen in concentration of at least 0.001 atomic percent and not more than 40 atomic percent, and has internal stress of at least $1 \times 10^8$ dyne/cm$^2$ and not more than $7 \times 10^9$ dyne/cm$^2$.

As the result of experiments, the inventors have also found that the internal stress of the hard carbon film according to this aspect of the present invention is reduced with the amount of the impurity. When Mo (molybdenum) was added in concentration of not more than 0.001 atomic percent, the internal stress of hard carbon film exceeded $7 \times 10^9$ dyne/cm$^2$ and the film was separated at a thickness of 4 $\mu$m. When Mo was added in excess of 40 atomic percent, on the other hand, the internal stress of hard carbon film was reduced below $1 \times 10^8$ dyne/cm$^2$ and the film was cracked at a thickness of 4 $\mu$m. Thus, it has been proved that internal stress of the hard carbon film must be within a range of at least $1 \times 10^8$ dyne/cm$^2$ and not more than $7 \times 10^9$ dyne/cm$^2$. It has also been experimentally proved that the concentration of the impurity element must be at least 0.001 atomic percent and not more than 40 atomic percent, in order to implement the said range of the internal stress of hard carbon film.

In particular, excellent characteristics can be attained with the impurity content of not more than 40 atomic percent, conceivably for the following reason: As such an impurity content is increased, the impurity element which is added to the hard carbon film grows in the form of cluster and starts to exist in the film. Thus, metallic characteristics appear in the hard carbon film, to reduce slidability and film hardness due to increase of the friction coefficient. When the impurity content is not more than 40 atomic percent, however, such clustery growth of the impurity element may conceivably be suppressed in the film, whereby deterioration of slidability and reduction of film hardness following such growth can be suppressed.

According to a further preferred aspect of the present invention, the hard carbon film contains an impurity element other than carbon and hydrogen in concentration of at least 0.001 atomic percent and not more than 1 atomic percent.

As the result of experiments, the inventors have found that the content of the impurity element is preferably in the range of 0.001 atomic percent and not more than 1 atomic percent. When Ti (titanium) is employed as an impurity element, internal stress of hard carbon film is reduced to about $5 \times 10^9$ dyne/cm$^2$ with an impurity content of 0.001 atomic percent and to about $6 \times 10^8$ dyne/cm$^2$ with an impurity content of about 1 atomic percent, with respect to internal stress of $2.2 \times 10^{10}$ dyne/cm$^2$ with no addition of such an impurity. When the content of titanium is 1 atomic percent, no separation is caused even if a hard carbon film of 10 $\mu$m in thickness is formed on an aluminum alloy. When the internal stress of hard carbon film is reduced below $1 \times 10^8$ dyne/cm$^2$, however, the hard carbon film is easily cracked upon application of external force. When the internal stress of hard carbon film exceeds $7 \times 10^9$ dyne/cm$^2$, on the other hand, separation is caused if the hard carbon film is formed in a thickness of at least about 5 $\mu$m. Also when Ti is added, therefore, internal stress of the hard carbon film must be within the range of $1 \times 10^8$ dyne/cm$^2$ to $7 \times 10^9$ dyne/cm$^2$.

When Ti is employed as the impurity element, further, its content must be at least 0.001 atomic percent and not more than 1 atomic percent, in order to implement the aforementioned internal stress of the hard carbon film. Therefore, the content of the impurity element is preferably at least 0.001 atomic percent and not more than 1 atomic percent.

The mechanism of reduction in internal stress of hard carbon film caused by addition of the impurity to the hard carbon film has not yet been sufficiently clarified. However, the internal stress of hard carbon film may be reduced conceivably because the impurity combines with dangling bonds (unpaired bonds) in carbon atoms contained in the film to be stabilized and the impurity atoms are incorporated in positions of the carbon atoms contained in the film in substitution for the carbon atoms to change the mean interatomic bond distance, thereby relaxing the stress.

When the hard carbon film is applied to a sliding part, the film must have a low friction coefficient. When a counter material of sliding is made of steel; ceramics such as SiC or $Si_3N_4$ has a friction coefficient of about 0.5. On the other hand, the friction coefficient of a conventional hard carbon film is about 0.2, i.e., lower than half that of ceramics, when a counter material of sliding is made of steel. Such a property of the hard carbon film conceivably results from its low surface energy. When surface energy is low, the friction resistance is not increased since the counter material hardly adsorb or adhere to the surface in sliding.

When the hard carbon film contains an impurity, however, its friction coefficient tends to slightly increase. When the impurity content is small, the friction coefficient substantially remains unchanged. When the impurity content exceeds 0.1 atomic percent, however, the friction coefficient of the hard carbon film is gradually increased. This may conceivably be because the impurity element as added starts to exist in the form of cluster, leading to appearance of metallic slidability. In order to sufficiently attain the merit of reduction in friction coefficient by coating of the hard carbon film, the friction coefficient is preferably not more than 0.25. Thus, the impurity content is preferably not more than about 1 atomic percent.

Hardness of a hard carbon film containing an impurity element is generally slightly lower than that of a film containing no impurity element. When the impurity is prepared from an element such as B or W which forms a hard carbide, reduction of hardness is substantially negligible. When the impurity is prepared from an element such as Au forming no carbide or the impurity element is dispersed in the film in a state of metal cluster due to a large content, however, hardness of the film is remarkably reduced.

In consideration of increase of the friction coefficient and reduction of the hardness as described above, the impurity content is preferably not more than 1 atomic percent. If the content of the impurity element is less than 0.001 atomic percent, internal stress of hard carbon film is so increased that it is impossible to form a hard carbon film having a thickness of not more than about 5 $\mu$m. Thus, the content of the impurity element is preferably within the range of at least 0.01 atomic percent and not more than 1 atomic percent.

According to a further preferred aspect of the present invention, at least one of the impurity element forms at least one of a carbide, a nitride and a carbo-nitride having Vickers hardness of at least 1000 kg/mm$^2$.

According to a further preferred aspect of the present invention, the impurity element consists of at least one element selected from a group of Ti (titanium), V (vanadium), Cr (chromium), Zr (zirconium), Nb (niobium), Mo (molybdenum), Hf (hafnium), Ta (tantalum) and W (tungsten).

According to a further preferred aspect of the present invention, the impurity element consists of at least one element selected from a group of B (boron), Au (gold), Pt (platinum) and Ag (silver).

The impurity element may be prepared from any element so far as the same can form impurity levels to transport electric charges, or has free electrons in a state of a simple substance of a compound. Preferably, the element can form a carbide having Vickers hardness of 1000 kg/mm$^2$. Such an element can be easily incorporated in the hard carbon film as a carbide having high hardness to minimize reduction in hardness caused by addition of the impurity, since excellent wear resistance which is originally provided in the hard carbon film can be easily maintained in this case. In more concrete terms, Ti, V, C, Zr, Nb, Mo, Hf, Ta and W are preferable among elements forming carbides. These elements form carbides in states of simple substances, which carbides have low electrical resistance values of $10^{-4}$ to $10^{-6}$ $\Omega \cdot$cm, to advantageously reduce electrical resistivity of the carbon film.

Further, nitrogen may be simultaneously added in addition to such an impurity element, to be contained in the hard carbon film in the form of a nitride or a carbo-nitride. Also in this case, the element can preferably form a nitride or a carbo-nitride having Vickers hardness of at least 1000 kg/cm$^2$. Most of elements forming carbides also form nitrides, and have small values of electrical resistivity. In particular, a nitride of Cr is a preferable material due to its excellent slidability.

On the other hand, the hard carbon film is generally known also as a chemically stable material, which exhibits its superiority under a wet atmosphere, environment containing NaCl, or inferior environment such as acid or alkaline environment. When the conductive hard carbon film according to the present invention is applied under such environment, the as-added impurity is preferably prepared from a stable material. While all carbides, nitrides and carbo-nitrides of the aforementioned Ti, V, Cr, Zr, Nb, Mo, Hf, Ta and W are stable, a metal element which is stable as a simple substance, such as Au, Pt or Ag, may be added in place. Such an element has self lubrication, and advantageously serves as a sliding material when the same is added to the hard carbon film. It has been proved that excellent slidability can be obtained also when B is added to the hard carbon film. Table 1 shows respective characteristics of the aforementioned elements, carbides and nitrides.

## Table 1

| Element | Electrical Resistivity ($\times 10^{-6}\Omega \cdot$cm) | Vickers Hardness | Element | Electrical Resistivity ($\times 10^{-6}\Omega \cdot$cm) | Vickers Hardness |
|---|---|---|---|---|---|
| Ti | 3 | 60 | Au | 2.04 | 25 |
| V | 18.2 | 55 | Pt | 9.81 | 39 |
| Cr | 12.7 | 130 | Ag | 1.51 | 26 |
| Zr | 40 | 60 | | | |
| Nb | 13.9 | 80 | | | |
| Mo | 5.2 | 160 | | | |
| Hf | 29.6 | 160 | | | |
| Ta | 12.6 | 70 | | | |
| W | 4.9 | 360 | | | |
| Carbide | Electrical Resistivity ($\times 10^{-6}\Omega \cdot$cm) | Vickers Hardness | Nitride | Electrical Resistivity ($\times 10^{-6}\Omega \cdot$cm) | Vickers Hardness |
| TiC | 70-173 | 2900-3200 | TiN | 22-130 | 1800-2100 |
| VC | 150-160 | 2800 | VN | 86 | 1500 |
| $Cr_3O_2$ | 70-80 | 1800 | CrN | 600-680 | 1000-1188 |
| ZrC | 50-64 | 2600 | ZrN | 11.5-14.0 | 1400-1600 |
| NbC | 74-254 | 2400 | NbN | 200 | 1400 |
| $Mo_2C$ | 97 | 1500 | - | - | |
| HfC | 60 | 2533-3202 | HfN | 32 | 1500-1700 |
| TaC | 20-175 | 1800 | TaN | 135 | 1060 |
| WC | 53 | 2400 | - | - | |

According to a further preferred aspect of the present invention, the hard carbon film has a friction coefficient of not more than 0.25 with respect to steel.

When the hard carbon film is formed on a surface of a substrate, a hard carbon film containing an impurity element other than carbon and hydrogen in concentration of less than 0.001 atomic percent may be formed on the substrate side, so that another hard carbon film containing an impurity element other than carbon and hydrogen in concentration of at least 0.001 atomic percent and not more than 1 atomic percent and having internal stress of at least $1 \times 10^8$ dyne/cm$^2$ and not more than $7 \times 10^9$ dyne/cm$^2$ is stacked on an outer surface side.

In general, the hard carbon film containing an impurity element is directly formed on the substrate, or an intermediate layer of an element such as Si or Ge belonging to the group IV of the periodic table or its compound is formed in order to improve adhesion strength, so that the hard carbon film is formed on this intermediate film. Further, a conventional hard carbon film or a crystalline diamond layer may be provided immediately under the hard carbon film containing an impurity element. This technique is effective when the hard carbon film containing an impurity element is slightly inferior in hardness to the conventional hard carbon film. It is possible to suppress deformation of the substrate with respect to external force by providing a layer having high hardness as an underlayer. Further, this structure is advantageous when the upper conductive hard carbon film containing an impurity is made to have an electric function since the hard carbon film or the diamond layer containing no impurity serves as an insulating layer. In addition, this structure is also applicable to a wire or a resistor which must have wear resistance.

In formation of the hard carbon film according to the present invention, the impurity can be added in any of the following methods:

(a) A method of supplying a gas containing the impurity element to a reaction system while the hard carbon film is formed by a well known method, to add the impurity element to the film. This method is effective particularly in plasma CVD, sputtering, ion plating and laser ablation.

(b) A method of evaporating a solid source containing an impurity element by heating or sputtering or ablating the same while the hard carbon film is formed by a well known method, to add the impurity element to the film. This method is effective particularly in sputtering, ion plating, ion beam sputtering and laser ablation.

(c) A method of irradiating the hard carbon film, being formed by a well known method, with an ion beam containing the impurity element, to add the impurity to the film.

(d) A method of forming the hard carbon film by a well known method and thereafter implanting ions containing the impurity, to add the same to the film.

The aforementioned methods may be independently applied or combined with each other for forming the hard carbon film containing the impurity. Further, the aforementioned methods may be combined with other methods.

The foregoing and other objects, features, aspects and advantages of the present invention will become more apparent from the following detailed description of the present invention.

DESCRIPTION OF THE PREFERRED EMBODIMENTS

Example 1

A parallel flat plate type high-frequency plasma CVD unit was employed to form hard carbon films under conditions of a methane gas flow rate of 2000 cc/min., a gas pressure of 0.1 Torr, a substrate temperature of $300°C$ and high-frequency power of 300 W. Under such fixed conditions, gaseous tungsten hexafluoride ($WF_6$) was added into the atmosphere, to form hard carbon films containing W. Substrates were prepared from Si, SUJ2 and glass, so that film thicknesses were 2 $\mu$m to 3 $\mu$m. The as-obtained hard carbon films were subjected to measurement of impurity concentration values and electrical resistivity levels, charge tests and measurement of friction coefficients and wear depths. Table 2 shows the results.

Table 2

| | No. | Flow Rate of $WF_6$ Gas (cc/min.) | W Concentration (at.%) | Electrical Resistivity ($\Omega\cdot$cm) | Charge Test Dust Concentration ($/mm^2$) | Friction Coefficient | Wear Depth ($\mu$m) |
|---|---|---|---|---|---|---|---|
| Comparative Samples | 1 | 0 | 0 | $5\times10^{12}$ | 15.8 | 0.08 | 0.15 |
| | 2 | 0.001 | 0.00001 | $2\times10^{7}$ | 9.2 | 0.09 | 0.14 |
| | 3 | 0.01 | 0.0001 | $8\times10^{5}$ | 1.2 | 0.11 | 0.15 |
| | 4 | 0.1 | 0.001 | $2.8\times10^{3}$ | 0.6 | 0.10 | 0.17 |
| Inventive Samples | 1 | 1 | 0.01 | $6.4\times10^{1}$ | 0.6 | 0.12 | 0.16 |
| | 2 | 10 | 0.3 | $2.9\times10^{-1}$ | 0.4 | 0.15 | 0.18 |
| | 3 | 100 | 2.5 | $3.3\times10^{-3}$ | 0.3 | 0.19 | 0.21 |
| | 4 | 1000 | 31.6 | $1.2\times10^{-4}$ | 0.2 | 0.27 | 0.32 |
| Comparative Samples | 5 | 2000 | 46.2 | $6.1\times10^{5}$ | 0.2 | 0.35 | 0.85 |
| | 6 | 4000 | 78.2 | $8.5\times10^{-6}$ | 0.2 | 0.58 | Adhered |

Measurement of impurity concentration was carried out on the films formed on the Si substrates, with SIMS for those having low concentration values and XPS for those having high concentration values. Measurement of electrical resistivity was carried out on the carbon films formed on the glass substrates in the form of strips having widths of 1 mm and lengths of 12 mm, to measure values at the room temperature by a four-probe method. As to the charge tests, the films formed on the SUJ2 substrates were employed and the surface of each film was rubbed with polyethylene 20 times, to count the number of dusts having sizes of at least 10 $\mu$m and adhering to the surface per unit area by electrification, with an optical microscope. Measurement of the friction coefficients and wear depths was carried out on the films formed on the SUJ 2 substrates with a pin-on-disk tester, under conditions of a counter pin of SUS 304 with a radius of curvature of 3 mm of, a load of 10 N, a sliding rate of 200 mm/sec. and 100000 sliding times. As the result of structural analysis by X-ray diffraction, it was confirmed that the films contained both of metallic W and WC.

Example 2

An ion plating unit was employed and methane gas was introduced up to 2 x $10^{-3}$ Torr, to form carbon films by reactive ion plating while evaporating various impurity elements from electron beam evaporation sources, under conditions of a substrate temperature of 400°C and high-frequency power of 200 W. Electron beam currents from the electron beam evaporation sources were adjusted to control evaporation rates, so that the films had impurity concentration values of about 2 percent. In addition of partial impurities, $N_2$ gas was introduced into the atmosphere by 5 x $10^{-4}$ Torr, to form the films under 2.5 x $10^{-3}$ Torr as a whole. The as-obtained hard carbon films were subjected to charge tests and measurement of friction coefficients and wear depths, by methods similar to those in Example 1. Table 3 shows the results.

Table 3

| No. | Impurity Element | Impurity Concentration (at.%) | Electrical Resistivity ($\Omega \cdot cm$) | Charge Test Dust Concentration (/mm$^2$) | Friction Coefficient | Wear Depty ($\mu$m) |
|---|---|---|---|---|---|---|
| 1 | Ti | 1.9 | 6.9x$10^{-3}$ | 0.3 | 0.18 | 0.20 |
| 2 | V | 2.0 | 2.1x$10^{-2}$ | 0.4 | 0.17 | 0.18 |
| 3 | Cr | 2.0 | 3.1x$10^{-2}$ | 0.3 | 0.14 | 0.20 |
| 4 | Zr | 2.1 | 1.5x$10^{-2}$ | 0.3 | 0.15 | 0.21 |
| 5 | Nb | 2.1 | 4.5x$10^{-2}$ | 0.4 | 0.16 | 0.22 |
| 6 | Mo | 1.9 | 9.7x$10^{-3}$ | 0.3 | 0.17 | 0.25 |
| 7 | Hf | 2.0 | 6.2x$10^{-3}$ | 0.4 | 0.17 | 0.18 |
| 8 | Ta | 2.2 | 1.1x$10^{-3}$ | 0.3 | 0.21 | 0.25 |
| 9 | W | 2.0 | 8.5x$10^{-3}$ | 0.3 | 0.20 | 0.20 |
| 10 | Au | 2.0 | 1.2x$10^{-3}$ | 0.3 | 0.09 | 0.27 |
| 11 | Pt | 2.0 | 7.5x$10^{-4}$ | 0.3 | 0.13 | 0.26 |
| 12 | Ag | 1.9 | 2.8x$10^{-4}$ | 0.2 | 0.09 | 0.29 |
| 13 | Ti N | 2.0 0.5 | 5.8x$10^{-3}$ | 0.3 | 0.19 | 0.22 |
| 14 | Cr N | 2.0 0.8 | 8.3x$10^{-2}$ | 0.4 | 0.13 | 0.19 |

Example 3

A parallel flat plate type high-frequency plasma CVD unit was employed to form hard carbon films under conditions of a methane gas flow rate of 2000 cc/min., a gas pressure of 0.1 Torr, a substrate temperature of 300°C and high-frequency power of 300 W. Various impurity elements were injected into the hard carbon films by ion implantation, under conditions of acceleration energy of 80 keV and an injection rate of $1 \times 10^{16}$ cm$^{-2}$, with maximum concentration of 0.5 atomic percent and mean concentration of about 0.03 atomic percent up to depths of 0.1 $\mu$m from the surfaces. The hard carbon films containing the as-injected impurities were subjected to measurement of electrical resistivity levels, Vickers hardness values and friction coefficients. Table 4 shows the results.

Table 4

| Impurity Element | Electrical Resistivity ($\Omega \cdot$cm) | Vickers Hardness | Friction Coefficient | Wear Depth ($\mu$m) |
|---|---|---|---|---|
| Ti | 13.4 | 2740 | 0.11 | 0.16 |
| W | 8.4 | 2380 | 0.13 | 0.17 |
| Au | 1.2 | 2050 | 0.07 | 0.17 |
| Pt | 2.0 | 2110 | 0.08 | 0.17 |

Example 4

Carbon films containing 5 atomic percent of Ti, Au, and Fe were formed on SUJ 2 substrates in a similar manner to Example 2. The as-obtained carbon films were subjected to various environment resistance tests. Table 5 shows the results. Referring to Table 5, circles show those unchanged after the tests, while crosses show those exhibiting abnormality such as discoloration or separation after the tests.

Table 5

| Test Conditions | Added Impurity | | |
|---|---|---|---|
| | Ti | Au | Fe |
| 80°C, 95% Humidity, 100 min. | o | o | x |
| 25°C, 3% Salt Water, 200 h. | o | o | x |
| 25°C, 5% Hydrochloric Acid, 24 h. | o | o | x |

Example 5

The surface of a cylindrical brush of stainless steel having a diameter of 20 mm was coated with a hard carbon film, which was formed by the method employed in Example 1 with addition of 10 atomic percent of Mo to have electrical resistivity of $8.1 \times 10^{-4}$ $\Omega \cdot$cm, in a thickness of 10 $\mu$m. This brush was mounted on a rotary shaft and driven at a rotational frequency of 30 r.p.m. for 24 hours. Another brush of graphite having the same shape was prepared with no coating, and subjected to a similar test. While both brushes exhibited excellent conduction, the surface of the graphite brush was worn by 0.4 mm after the test, although the stainless steel brush which was coated with the carbon film was substantially unworn.

Example 6

An ion plating unit was employed and methane gas was introduced up to $2 \times 10^{-3}$ Torr, to form carbon films by reactive ion plating while evaporating Mo from an electron beam evaporation source, under conditions of a substrate temperature of 200°C and high-frequency power of 300 W. The electron beam current from the electron beam evaporation source was adjusted to control the evaporation rates. The as-obtained hard carbon films were subjected to measurement of Mo concentration values, internal stress values and friction coefficients. The Mo concentration values and the friction coefficients were measured in methods similar to those in Example 1, while the internal stress values were calculated by measuring warping of substrates provided with the films. The films were formed basically in a similar manner to Example 2. Table 6 shows the results.

Table 6

| No. | | Electron Beam Current (mA) | Mo Concentration (at.%) | Internal stress ($\times 10^9$ dyne/cm$^2$) | Friction Coefficient | Possibilty of Formation of Film in Thickness of 4 μm |
|---|---|---|---|---|---|---|
| Comparative Samples | 1 | 0 | 0 | 22 | 0.18 | Separated |
| | 2 | 10 | 0.00001 | 10 | 0.17 | Separated |
| Inventive Samples | 1 | 30 | 0.001 | 6.8 | 0.17 | Excellent |
| | 2 | 50 | 0.01 | 6.5 | 0.16 | Excellent |
| | 3 | 60 | 0.1 | 5.3 | 0.17 | Excellent |
| | 4 | 70 | 1.0 | 5.0 | 0.15 | Excellent |
| | 5 | 80 | 2.9 | 4.9 | 0.17 | Excellent |
| | 6 | 100 | 19.6 | 1.2 | 0.19 | Excellent |
| | 7 | 200 | 39.1 | 0.1 | 0.25 | Excellent |
| Comparative Samples | 3 | 300 | 43.5 | 0.05 | 0.35 | Cracked |
| | 4 | 400 | 67.4 | 0.01 | 0.58 | Cracked |

Example 7

An ion plating unit was employed and methane gas was introduced up to 2 x 10$^{-3}$ Torr, to form carbon films by reactive ion plating while evaporating various impurity elements from electron beam evaporation sources, under conditions of a substrate temperature of 400°C and high-frequency power of 200 W. Electron beam currents of the electron beam evaporation sources were adjusted to control evaporation rates, so that the films contained impurities in concentration of about 25 percent. In addition of partial impurities, N$_2$ gas was introduced into the atmosphere by 5 x 10$^{-4}$ Torr, to form film under 2.5 x 10$^{-3}$ Torr as a whole. The as-obtained hard carbon films were subjected to measurement of impurity concentration values, internal stress values, electrical resistivity levels and friction coefficients. The impurity concentration values, electrical resistivity levels and friction coefficients were measured in methods similar to those in Example 1. The internal stress values were calculated by measuring warping of substrates provided with the films. The films were formed basically in a similar manner to Example 2. Table 7 shows the results.

Table 7

| No. | Impurity Element | Impurity Concentration (at.%) | Internal stress (x$10^9$ dyne/cm$^2$) | Electrical Resistivity (Ω•cm) | Friction Coefficient |
|---|---|---|---|---|---|
| 1 | B | 24.9 | 4.9 | 5.6x$10^{-3}$ | 0.18 |
| 2 | Ti | 25.1 | 3.1 | 5.2x$10^{-4}$ | 0.19 |
| 3 | V | 25.2 | 4.2 | 3.5x$10^{-3}$ | 0.17 |
| 4 | Cr | 25.5 | 3.6 | 3.1x$10^{-3}$ | 0.16 |
| 5 | Zr | 23.6 | 3.8 | 2.2x$10^{-3}$ | 0.16 |
| 6 | Nb | 23.6 | 3.2 | 5.1x$10^{-3}$ | 0.16 |
| 7 | Mo | 25.7 | 3.0 | 9.0x$10^{-4}$ | 0.17 |
| 8 | Hf | 25.8 | 4.5 | 6.9x$10^{-4}$ | 0.18 |
| 9 | Ta | 25.8 | 5.0 | 2.0x$10^{-3}$ | 0.21 |
| 10 | W | 24.2 | 4.9 | 9.4x$10^{-4}$ | 0.21 |
| 11 | Au | 26.2 | 3.2 | 1.7x$10^{-4}$ | 0.11 |
| 12 | Pt | 27.1 | 3.5 | 8.2x$10^{-5}$ | 0.12 |
| 13 | Ag | 28.7 | 3.3 | 3.2x$10^{-5}$ | 0.09 |
| 14 | Ti<br>N | 20.5<br>9.9 | 4.2 | 6.1x$10^{-4}$ | 0.19 |
| 15 | Cr<br>N | 15.1<br>12.0 | 4.1 | 7.9x$10^{-3}$ | 0.15 |

Example 8

A high-frequency plasma CVD unit having parallel flat type electrodes was employed to form hard carbon films under conditions of a methane gas flow rate of 300 cc/min., a gas pressure of 0.1 Torr, a substrate temperature of 200°C and high-frequency power of 300 W. Under such fixed conditions, diborane gas diluted with 1 percent or argon or titanium tetrachloride diluted with 5 percent of hydrogen was added to the atmosphere, to form hard carbon films containing impurities.

The as-obtained hard carbon films were subjected to measurement of impurity concentration values, internal stress values, friction coefficients with respect to steel, Vickers hardness values and electrical resistivity levels. As to the hard carbon films, further, investigation was made as to possibility of forming films having thicknesses exceeding 5 μm. Tables 8 and 9 show the results.

Table 8

| | Flow Rate of Diborane Gas (cc/min.) | Impurity Concentration (at.%) | Internal Stress ($10^9$ dyne/cm$^2$) | Friction Coefficient | Vickers Hardness (kg/mm$^2$) | Electrical Resistivity ($\Omega \cdot$cm) | Possibility of Formation of Film in Thickness of 5 μm |
|---|---|---|---|---|---|---|---|
| 1 | 0 | 0 | 22 | 0.18 | 6200 | $3\times10^9$ | x |
| 2 | 0.3 | 0.0005 | 8.1 | 0.20 | 5300 | 430 | △ |
| 3 | 0.5 | 0.001 | 6.9 | 0.19 | 4600 | 108 | o |
| 4 | 3.0 | 0.005 | 5.7 | 0.19 | 4100 | 23 | o |
| 5 | 10 | 0.022 | 3.9 | 0.20 | 3500 | 3.41 | o |
| 6 | 30 | 0.061 | 2.5 | 0.19 | 2900 | 0.851 | o |
| 7 | 100 | 0.19 | 1.0 | 0.20 | 2400 | 0.186 | o |
| 8 | 300 | 0.58 | 0.7 | 0.22 | 1700 | 0.023 | o |
| 9 | 500 | 0.98 | 0.4 | 0.24 | 1580 | 0.0042 | o |
| 10 | 1000 | 1.98 | 0.08 | 0.28 | 1390 | 0.00049 | o |
| 11 | 2000 | 3.89 | 0.05 | 0.32 | 1230 | 0.000025 | o |

Table 9

| | Flow Rate of Titanium Tetrachloride Gas (cc/min.) | Impurity Concentration (at.%) | Internal Stress ($10^9$ dyne/cm$^2$) | Friction Coefficient | Vickers Hardness (kg/mm$^2$) | Electrical Resistivity ($\Omega \cdot$cm) | Possibility of Formation of Film in Thickness of 5 μm |
|---|---|---|---|---|---|---|---|
| 1 | 0 | 0 | 22 | 0.18 | 6200 | $3\times10^9$ | x |
| 2 | 0.05 | 0.0003 | 10.2 | 0.19 | 6000 | 120 | x |
| 3 | 0.1 | 0.0006 | 6.4 | 0.20 | 5400 | 72 | o |
| 4 | 0.3 | 0.0014 | 4.7 | 0.19 | 5500 | 23 | o |
| 5 | 0.5 | 0.0025 | 3.4 | 0.20 | 4700 | 5.6 | o |
| 6 | 3.0 | 0.015 | 2.9 | 0.20 | 4300 | 1.5 | o |
| 7 | 10 | 0.049 | 1.8 | 0.21 | 3800 | 0.25 | o |
| 8 | 30 | 0.16 | 0.9 | 0.19 | 2900 | 0.071 | o |
| 9 | 100 | 0.52 | 0.66 | 0.20 | 2800 | 0.0022 | o |
| 10 | 300 | 1.9 | 0.58 | 0.23 | 2600 | 0.00018 | o |
| 11 | 500 | 3.0 | 0.30 | 0.24 | 2300 | 0.00081 | o |
| 12 | 1000 | 5.3 | 0.32 | 0.31 | 2100 | 0.000032 | o |
| 13 | 2000 | 12.1 | 0.21 | 0.38 | 2300 | 0.000018 | o |

Example 9

A high frequency plasma CVD unit having parallel flat plate electrodes was employed to form a hard carbon film on an aluminum substrate under conditions of a methane gas flow rate of 300 cc/min., a gas pressure of 0.1 Torr, a substrate temperature of 200°C and high-frequency power of 300 W. First, a hard carbon film of 5000 Å in thickness was grown on the aluminum substrate by film formation for 40 minutes. Au ions were injected into a region of 1 mm in width and 20 mm in length of this hard carbon film with an ion implantation unit, under ion implantation conditions of acceleration energy of 80 keV and an injection rate of $1 \times 10^{16}$/cm$^2$. The Au ions injected as the impurity element were distributed in a range of up to 0.1 $\mu$m in depth from the surface of the hard carbon film. The hard carbon film exhibited impurity concentration (Au concentration) of 0.5 atomic percent at the maximum.

The as-obtained hard carbon film exhibited electrical resistivity of 120 $\Omega$ across the region into which the impurity was injected, while this region exhibited electrical resistivity in excess of about 10 $\Omega \cdot$cm. This region of the hard carbon film was insulated from the aluminum substrate by a resistance of 800 M$\Omega$. In other words, only a surface of the region containing the impurity ions was conductive, while a region on the aluminum substrate side containing no impurity ions remained in a state of a general hard carbon film of high resistance. This hard carbon film exhibited a friction coefficient of 0.21 in each of the regions containing the impurity ions and no impurity ions. Further, the hard carbon film exhibited Vickers hardness of 4800 in the region containing the impurity ions, and that of 6200 in the region containing no impurity ions.

According to the present invention, as hereinabove described, it has been possible to obtain a hard carbon film having both of excellent wear resistance and high conductivity.

Thus, it is possible to provide an ideal sliding material being applicable to a sliding part which must be in electrical contact such as a part of an audio-visual apparatus, an office automation product or a transmission part, or a non-lubricant sliding part which must be free from electrification.

According to the present invention, further, it has been possible to obtain a hard carbon film which can sufficiently maintain excellent slidability with small internal stress.

Thus, it is possible to form a hard carbon film in a relatively small thickness also on a substrate having low hardness while sufficiently maintaining excellent slidability.

Although the present invention has been described in detail, it is clearly understood that the same is by way of illustration and example only and is not to be taken by way of limitation, the spirit and scope of the present invention being limited only by the terms of the appended claims.

## Claims

1. An amorphous hard carbon film being mainly composed of carbon, or carbon and hydrogen, and containing at least one impurity element other than carbon and hydrogen, said hard carbon film having electrical resistivity of at least $1 \times 10^{-6}$ $\Omega \cdot$cm and not more than $1 \times 10^2$ $\Omega \cdot$cm at the room temperature.

2. A hard carbon film in accordance with claim 1, wherein said impurity element is contained in concentration of at least 0.001 atomic percent and not more than 40 atomic percent.

3. A hard carbon film in accordance with claim 1, wherein at least one of said impurity element is an element forming at least one of a carbide, a nitride and a carbo-nitride having Vickers hardness of at least 1000 kg/mm$^2$.

4. A hard carbon film in accordance with claim 3, wherein said impurity element consists of at least one element selected from a group of Ti, V, Cr, Zr, Nb, Mo, Hf, Ta and W.

5. A hard carbon film in accordance with claim 1, wherein said impurity element consists of at least one element selected from a group of B, Au, Pt and Ag.

6. A hard carbon film in accordance with claim 1, having a friction coefficient of not more than 0.25 with respect to steel.

7. An amorphous hard carbon film being mainly composed of carbon, or carbon and hydrogen, and containing at least one impurity element other than carbon and hydrogen, said impurity element other than carbon and hydrogen being contained in concentration of at least 0.001 atomic percent and not more than 40 atomic percent, said hard carbon film having internal stress of at least $1 \times 10^8$ dyne/cm$^2$ and not more than $7 \times 10^9$ dyne/cm$^2$.

14

8. A hard carbon film in accordance with claim 7, wherein said impurity element is contained in concentration of at least 0.001 atomic percent and not more than 1 atomic percent.

9. A hard carbon film in accordance with claim 7, wherein at least one of said impurity element is an element forming at least one of a carbide, a nitride and a carbo-nitride having Vickers hardness of at least 1000 kg/mm$^2$.

10. A hard carbon film in accordance with claim 9, wherein said impurity element consists of at least one element selected from a group of Ti, V, Cr, Zr, Nb, Mo, Hf, Ta and W.

11. A hard carbon film in accordance with claim 7, wherein said impurity element consists of at least one element selected from a group of B, Au, Pt and Ag.

12. A hard carbon film in accordance with claim 7, having a friction coefficient of not more than 0.25 with respect to steel.

13. An amorphous hard carbon film being formed on a surface of a substrate and mainly composed of carbon, or carbon and hydrogen, wherein
    a first hard carbon film containing an impurity element other than carbon and hydrogen in concentration of less than 0.001 atomic percent is formed on said substrate side and a second hard carbon film containing an impurity element other than carbon and hydrogen in concentration of at least 0.001 atomic percent and having internal stress of at least $1 \times 10^8$ dyne/cm$^2$ and not more than $7 \times 10^9$ dyne/cm$^2$ is formed on an outer surface side.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EXTENDED ABSTRACTS, SPRING MEETING, LOS ANGELES, CA vol. 89, no. 1, 1989, PRINCETON page 133 KLAGES ET AL 'properties and microstructure of metal containing A-C-H films' * page 133, column 1, paragraph 1 * * page 133, column 2, paragraph 1 * | 1-2,4-5, 9-11 | C23C16/26 C23C14/06 |
| A | --- | 3,6-8,12 | |
| X | APPLIED PHYSICS LETTERS vol. 50, no. 16, 20 April 1987, NEW YORK pages 1056 - 1058 H.DIMIGEN ET AL 'tribological and electrical properties of metal-containing hydrogenated carbon films' * the whole document * | 1-2,6-8, 12 | |
| A | --- | 3-5,9-12 | |
| X | EP-A-0 419 090 (SHARP) * column 1, last paragraph - column 2, paragraph 1 * --- | 13 | TECHNICAL FIELDS SEARCHED (Int. Cl.5 ) |
| T | EP-A-0 538 797 (SUMITOMO ELECTRICAL INDUSTRIES) * page 2, line 38 - line 40 * * page 3, line 1 - line 40 * ----- | 1-12 | C23C |

The present search report has been drawn up for all claims

| Place of search | Date of completion of the search | Examiner |
|---|---|---|
| THE HAGUE | 25 OCTOBER 1993 | SCHMIDT H.R. |